# EUROPEAN PATENT SPECIFICATION

(11) **EP 1 577 940 B1**
(45) Date of publication and mention of the grant of the patent: **05.04.2017**
(21) Application number: 05003844.7
(22) Date of filing: 23.02.2005
(51) Int. Cl.: H01L 21/768

(54) **Method of manufacturing a semiconductor device having damascene structures with air gaps**
Verfahren zur Herstellung einer Halbleitervorrichtung mit Damaszenstrukturen mit Luftzwischenräumen
Procédé pour la fabrication d'un dispositif semiconducteur ayant des structures damascene avec entrefers

(30) Priority: 17.03.2004 EP 04101097
(43) Date of publication of application: 21.09.2005
(73) Proprietor: IMEC, 3001 Leuven (BE); NXP B.V., 5656 AG Eindhoven (NL)
(72) Inventor: Daamen, Roel, 6061 NE Posterholt (NL); Hoang, Viet Nguyen, 2625 JB Delft (NL)
(74) Representative: DenK iP

(56) References cited:
- WO-A2-03/085719
- WO-A2-2004/001842
- US-A- 5 380 546

## Description

The invention relates to a method of manufacturing a semiconductor device having damascene structures with air gaps.

The trend towards integrated circuits with deep submicron technology (i.e., involving feature sizes of less than 0.35 microns) has increased the need for multi-layer interconnects. The performance of integrated circuits in the deep submicron regime is increasingly dependent on the communication delay, i.e. the delay time of electronic signals traveling between the millions of gates and transistors present on the typical integrated circuits. As a result, capacitance and resistance effects resulting from the passive interconnect structures are increasingly becoming important and do have to be well-controlled.

One way to solve the above problems is to use low resistance metals (e.g., copper) in conjunction with insulating materials with low dielectric constants ("low-k dielectrics") between metal lines. A low-k dielectric is a dielectric material which exhibits a substantially lower dielectric constant than conventional dielectric materials such as silicon dioxide.

Based on considerable efforts optical lithography techniques have been able to keep up with deep submicron requirements using techniques such as off-axis illumination, phase shifting masks, and other methods known in the art. However, the achieved increase in resolution comes at the expense of a decrease in the depth of focus. Therefore, highly planar surfaces are required during intermediary process steps. To achieve highly planar surfaces, traditional metal deposition and photolithographic techniques become progressively more ineffective as line widths are scaled down and multiple layers of metal are used.

Chemical-Mechanical Polishing (CMP) is increasingly being used in the fabrication of interconnect layers for modem integrated circuits especially with more than three layers. The metal lines thereof usually comprise a high aspect ratio (e.g., lines in the order of 0.25 µm in width and in the order of 1.0 µm in height). For more details on CMP please refer to the introductory part of US 6,071,809.

A typical semiconductor manufacturing technique based on CMP techniques is the so-called damascene process. A damascene process comprises the steps of forming patterns in a dielectric layer, filling these patterns with an interconnect metal, removing the excess metal on the wafer surface by polishing and leaving inlaid interconnect metal features.

Basically two damascene processes exist, namely the single-damascene and the dual-damascene process. In a single damascene process, a lower conductor is formed on a substrate and is coated with a first dielectric layer. The lower conductor is contacted by patterning the first dielectric layer and forming a conductive plug in the first dielectric layer. Thereafter, a second dielectric layer deposited on the first dielectric layer is patterned and an interconnect wiring metallization is formed in the patterned second dielectric layer. In addition a dielectric is deposited, the structures are etched and the metal is filled and planarized resulting in inlaid metal structures. During the fabrication and the interconnecting using single damascene processing, every layer is done separately, i.e. a single damascene trench level followed by single damascene via level. However, in a dual-damascene process, the interconnect metal wiring and the conductive plug are formed by patterning both the via and the trench patterns into the first dielectric layer. Thereafter, the via and the trench are filled simultaneously with metal. The dual damascene process provides a simple and low-cost manufacturing technique.

Copper is preferred over aluminum for interconnect metallization as its conductivity is relatively high, i.e. low resistance, and it is less susceptible to electromigration failure than many other metals. On the other hand, the use of Cu as interconnect metal introduces new problems, since bringing copper into contact with silicon or silicon dioxide may lead to devastating results. This is because copper migrates or diffuses into the silicon dioxide, thereby increasing leakage currents or actually shorting-out adjacent conductors. Accordingly, some kind of Cu diffusion barriers around copper conductors must be introduced. In the above damascene structures, the inner surfaces (i.e., the bottom and sides of the via and trench) are typically coated with a thin layer of Ti, TiN, Ta, TaN, WN or another adequate barrier metal. The top surface of a Cu conductor is then typically capped with a layer of silicon nitride or another barrier material after the inlaid Cu conductors are formed by CMP. Silicon nitride, silicon carbide or silicon carbonitride is typically used as it is an effective diffusion barrier for copper.

In US 6,071,809 a typical prior art low-k dual-damascene structure is shown, which includes copper conductors formed on a substrate with a dielectric (e.g., silicon dioxide or a low-k dielectric). A nitride cap layer is formed on copper conductors, which is followed by a low-k dielectric layer, an etch stop silicon dioxide layer, a second low-k dielectric layer, and a hard mask silicon dioxide layer. Using standard etching techniques, vias and trenches are patterned in the low-k dielectrics, and the copper interconnect metal and any seed and barrier layers are deposited to form the connection to conductors. The cap layer typically consists of silicon nitride and the hard mask layer typically consists of silicon dioxide.

Usually, advanced low-k materials have a bulk k-value of approximately 2, while air has a k-value of 1. Therefore, the use of air gaps instead of low-k materials would lead to a significant reduction of parasitic capacitance. One example of a damascene structure with air gaps is shown in WO 02/19416. A standard dual damascene structure is manufactured as described in US 6,071,809. Said dual damascene structure comprises a metal layer, a first dielectric layer as via dielectric (low-k dielectrics such as siloxane or a polyarylene ether), a second dielectric layer (such as SOG, NanoglassTM or a polymer like SiLK) disposed on said first dielectric layer as trench level dielectric with an interconnect groove. In addition, an etch stop layer (such as SiN) is present between the first dielectric layer and the second dielectric layer. Metal, preferably copper Cu, fills the via and the interconnect groove, forming a metal line having an upper side. A barrier and the Cu seed layer is provided on the walls of the via and the interconnect groove before depositing the Cu. The second dielectric layer is removed so that the metal which has filled the interconnect grove at trench level is laid open, i.e. the second dielectric layer is used as a sacrificial layer for defining the metal lines. A non-conductive barrier layer (like silicon nitride or silicon carbide) is provided over the laid open metal line and the laid open etch stop layer. A disposable layer is deposited on the etch stop layer and the metal line. Thereafter, the disposable layer is planarized down to the upper side of the metal line. A porous dielectric layer is spun on the disposable layer, and the disposable layer is removed or decomposed through the porous dielectric layer in order to form air gaps. The air gaps are obtained through a curing and baking step possibly assisted with UV treatment.

The spin-on material of the porous dielectric layer comprises a polymer which can be volatilized or degraded to smaller molecules, like PMMA (polymethyl methacrylate), polystyrene, and polyvinyl alcohol. Alternatively, a UV photoresist may also be used as the basic material for the manufacture of air gaps, and a plasma CVD layer or a spin-on dielectric layer is used for the porous dielectric layer. The porous dielectric layer preferably comprises a low-k dielectric such as SiLK, provided in a spin coating process. A plasma CVD layer may also be used as the porous dielectric layer.

WO 2004/001842 discloses a layer assembly and a method for producing the layer assembly. The layer assembly comprises a layer that is placed on a substrate. Said layer comprises a first partial region, which is made of a decomposable material, and an adjacent second partial region with a useful structure made of a non-decomposable material. The layer assembly also has a top layer which is arranged on the layer made of a decomposable material and the useful structure. The layer assembly is designed so that the decomposable material can be removed from the layer assembly by diffusing the decomposable material through the covering layer.

It is an object of the invention to provide an improved method of manufacturing a semiconductor device with damascene structure and air gaps.

This object is achieved by a method of manufacturing a semiconductor device having damascene structures with air gaps according to claim 1.

Therefore, a method of manufacturing a semiconductor device having damascene structures with air gaps is provided. The method comprises the steps of depositing and patterning a disposable layer, depositing a first barrier layer on top of the patterned disposable layer, depositing a metal layer, planarizing said metal layer, depositing a second barrier layer, planarizing said second barrier layer until substantially no barrier layer material is present on top of said disposable layer, depositing a permeable layer, removing said disposable layer through said permeable layer to form air gaps.

As a result of the introduction of a second barrier layer, the metal lines are encapsulated and passivated without a barrier layer causing a decrease of the available air gaps space or an increase of the effective k-value of the air gap leading to higher unwanted RC-delays.

According to an aspect of the invention, said first and second barrier layers (BL1, BL2) comprise conductive material.

According to a further aspect of the invention, the disposable layer is formed of a photoresist layer or an organic polymer with a low mass. Such a disposable layer can be easily decomposed by heating the structure, leading to an effective way of creating the air gaps.

According to a further aspect of the invention, said patterning and etching of said disposable layer is adapted to form additional patterns in said disposable layer to provide metal dummy structures in the disposable layer after said removing step. These metal dummy structures improve the mechanical stability of the air gaps.

According to the invention, a single CVD reactor is used for performing the removing step by heating in order to decompose the disposable layer and for depositing a dielectric layer in a subsequent step. Thus, the usage of a stand-alone oven for decomposing the disposable layer can be omitted, thereby decreasing the required amount of apparatus and increasing the throughput.

The invention is based on the idea to use a conductive barrier material to encapsulate and passivate merely the metal lines without covering the disposable layer by means of two barrier deposition steps.

Other aspects of the inventions are defined in the dependent claims.

These and other aspects of the invention are apparent from and will be elucidated with reference to the embodiment(s) described hereinafter.

Figs. 1 to 9 show a number of processing steps according to a method of manufacturing a semiconductor device:
Fig. 1 shows a cross section of a semiconductor device according to the invention as a starting point,
Fig. 2 shows a cross section of the device of Fig. 1 after patterning the deposited photoresist layer,
Fig. 3 shows a cross section of the device of Fig. 2 after a first barrier layer deposition and a seed layer deposition,
Fig. 4 shows a cross section of the device of Fig. 3 after a metal plating step,
Fig. 5A shows a cross section of the device of Fig. 4 after a planarization step, which leaves the barrier layer intact,
Fig. 5B shows a device of Fig. 4 after a planarization step, which removes the barrier layer on top of the photoresist layer,
Figs. 6A and 6B show a cross section of the device of Figs. 5A and 5B after a second barrier deposition,
Fig. 7A and 7B show a cross section of the device of Fig. 6A and 6B after removing the barrier layer from the photoresist layer,
Figs. 8A and 8B show a cross section of the device of Figs. 7A and 7B, respectively, after depositing a permeable dielectric layer,
Figs. 9A and 9B show a cross section of the device of Figs. 8A and 8B, respectively, after decomposing the photoresist layer.

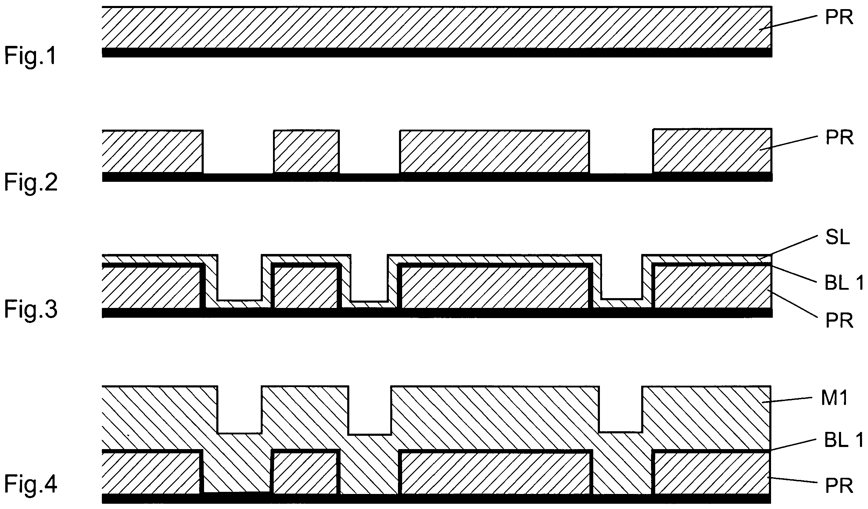

Figure 1 shows a cross section of a semiconductor device as a starting point for the manufacturing process according to a first preferred embodiment of the invention. In particular, a photoresist PR is deposited on a first layer. This deposition is preferably performed by spin-coating. Alternatively, other starting points may be possible.

Figure 2 shows a cross section of the device of Figure 1 after the photoresist PR was patterned. This can be performed by means of known lithography processes.

Figure 3 shows a cross section of the device of Figure 2 after a first diffusion barrier layer deposition and a seed layer deposition. The first diffusion barrier layer deposition and the Cu seed layer deposition are performed by physical vapor deposition PVD, CVD or ALCVD or a combination of those techniques. The first barrier layer BL1 may comprise a conductive material like tungsten nitride, titanium, titanium nitride, titanium silicide, tantalum, tantalum nitride or other materials which prevent the diffusion of metal items between unlike materials. The seed layer may comprise copper.

Figure 4 shows a cross section of the device of Figure 3 after a well-known copper plating step.

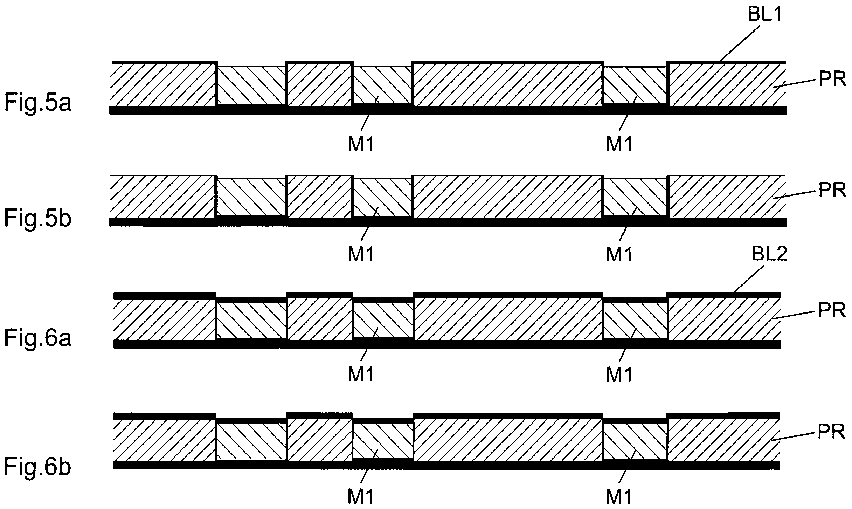

Figure 5A shows a cross section of a device of Figure 4 after a planarization step. The planarization of copper is performed by chemical mechanical polishing CMP. This polishing is performed until the first diffusion barrier layer BL1 is exposed.

Figure 5B shows a cross section of the device of Figure 4 after a planarization step. The planarization of the metal is performed by chemical mechanical polishing CMP. The polishing is continued until the copper as well as the first barrier layer BL1 on top of the photoresist PR is removed.

Figures 6A and 6B show cross sections of a device of Figures 5A and 5B, respectively, after a second diffusion barrier layer deposition step. The second diffusion barrier layer deposition may be performed in the same manner as the first diffusion barrier layer deposition, as described with regard to Figure 3. The second barrier layer BL2 may comprise a conductive material like tungsten nitride, titanium, titanium nitride, titanium silicide, tantalum, tantalum nitride or other materials which prevent the diffusion of metal items between unlike materials.

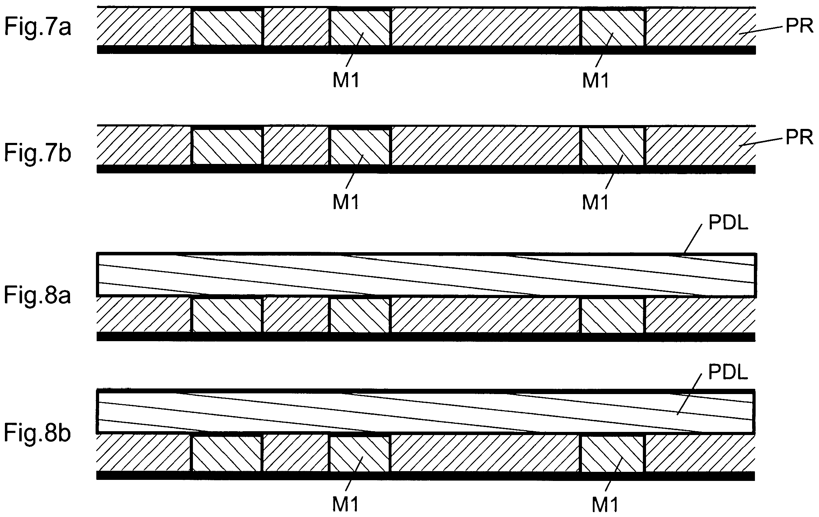

Figures 7A and 7B show cross sections of the device of Figures 6A and 6B, respectively, after removing the second barrier layer BL2 on top of the resist PR. This is performed again by means of chemical mechanical polishing CMP or dry etching. The polishing is continued until the barrier layer on top of the photoresist PR is removed. However, the second barrier layer BL2 will remain present on top of the metal layer M1. Thus, the metal layer M1 is encapsulated and passivated by the first diffusion layer BL1 covering the bottom and the side walls as well as by the second barrier layer BL2 covering the top parts of the metal layer.

Figures 8A and 8B show cross sections of the devices of Figures 7A and 7B, respectively, after depositing a permeable dielectric layer PDL on top. This dielectric material is preferably porous as well as permeable and has a low-k value. The deposition is performed by spin coating on the CMP-treated surface of the photoresist and the second barrier layer BL2 on top of the metal layer. Alternatively, a PECVD deposition is also possible to deposit a porous dielectric layer.

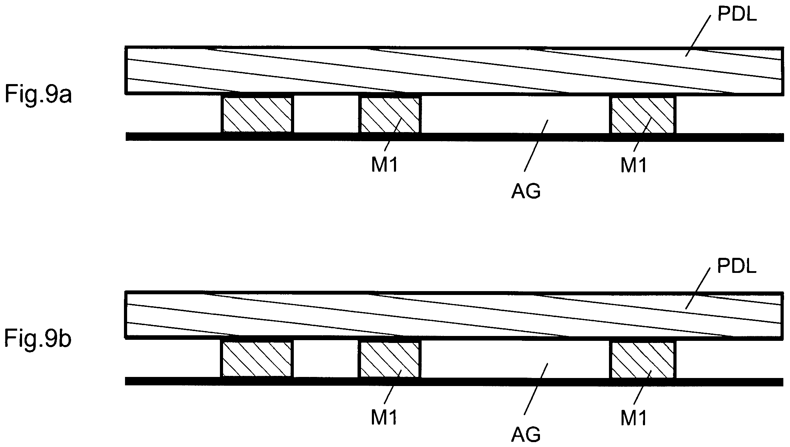

Figures 9A and 9B show cross sections of the devices of Figures 8A and 8B, respectively, after decomposition of the photoresist layer PR. The photoresist layer is used as a sacrificial material. It is decomposed by heating the wafer. The photoresist PR decomposes and diffuses through the permeable dielectric material. Finally, the required air gaps AG are present in the volume occupied previously by the decomposed material.

In other words, the copper layer is capped before the permeable via-layer is deposited. However, also other capping methods may be implemented, like self-aligned electroless barrier deposition, such as CoWP or CoWB and even an SiC/Si3N4 etc. deposition followed by a lithography step and an etch step removing a liner from the top of the spacing, but leaving it on the copper, thus capping/passivating this layer.

The above mentioned semiconductor manufacturing process may be used in all CMOS, RFCMOS and BiCMOS processes.

A semiconductor device manufactured as described above will differ from prior art semiconductor devices as a very small amount of carbon-like material may be found inside the air gaps. In particular the carbon-like material may be found at the interface of the barrier layer protecting the copper. However, by process optimization almost totally clean air gaps can be achieved, especially by the use of cleaner air gap material or the use of special cleaning techniques, such as supercritical cleaning methods. In addition, the copper line will be totally encapsulated by the conductive barrier layer material.

According to a second embodiment which is based on the first embodiment, metal dummies are introduced into the air gaps to increase the mechanical stability thereof. This may be achieved by adapting the lithography step as depicted in Figure 2 such that additional gaps are introduced into the resist layer PR. These additional gaps should be formed between the metal lines to be manufactured. Thereafter, the diffusion barrier layer deposition, the seed layer deposition and the subsequent processing steps as described according to the first embodiment are performed. Since the additional gaps in the photoresist are arranged at positions in between the metal lines M1 and are filled with copper, the copper in the additional trenches is not interconnected with other metal lines and thus merely serves for increasing the stability of the air gaps.

According to any embodiment, the throughput of the air gap formation process is increased by using the same CVD reactor for performing the heating step to decompose the disposable layer and for depositing the dielectric layer of a subsequent step. Preferably, the heating is performed under an inert gas environment, like a nitrogen environment. Thus, the usage of a stand-alone oven for the decomposition of the disposable layer can be omitted, thereby decreasing the required amount of apparatus and increasing the throughput. In other words, only one CVD reactor is used for decomposing the sacrificial layer to form the air gap and for subsequently depositing a CVD dielectric layer with a low k-value.

Instead of the photoresist used as a disposable layer in the above embodiments, any organic polymer with a low mass, i.e. low amu, that decomposes somewhere between 300-500 DEG C, preferably between 350-450 DEG C, may be chosen, since this layer will be decomposed.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. In the device claim enumerating several means, a number of these means can be embodied by one and the same item of hardware. The mere fact that certain measures are recited in mutually different dependent claims does not indicate that a combination of these measures cannot be used to advantage.

Furthermore, any reference signs in the claims shall not be construed as limiting the scope of the claims.

## Claims

1. A method of manufacturing a semiconductor device having a damascene structure with air gaps, comprising the steps of:
- depositing a disposable layer (PR) and patterning the disposable layer so as to form at least one pattern for a damascene process,
- depositing a first barrier layer (BL1) on top of the patterned disposable layer,
- depositing a metal layer (M1) thereby filling the pattern,
- planarizing said metal layer (M1) thereby forming a metal line,
- depositing a second barrier layer (BL2) on the planarized metal layer and the disposable layer thereby encapsulating the metal lines,
- planarizing said second barrier layer (BL2) until no barrier layer is present on top of the disposable layer (PR) and thereby leaving the barrier layer on top of the metal lines,
- depositing a permeable dielectric layer (PDL) on the disposable layer and on top of the planarized metal layer after planarizing said second barrier layer (BL2), and
- removing said patterned disposable layer (PR) through said permeable dielectric layer (PDL) to form a damascene structure with air gaps (AG); and
**characterized in that** a single CVD reactor is used for performing the removing step by heating in order to decompose the disposable layer (PR) and for depositing a dielectric layer in a subsequent step.

2. Method according to claim 1, wherein said first and second barrier layers (BL1, BL2) are conductive.

3. Method according to claim 1 or 2, wherein said disposable layer (PR) is a photoresist layer or an organic polymer with a low mass.

4. Method according to any one of claims 1 to 3, wherein said patterning of said disposable layer (PR) is adapted to form additional patterns in said disposable layer (PR) to provide metal dummy structures in the airgap after said removing step.

## Patentansprüche

1. Verfahren zum Herstellen einer Halbleitervorrichtung, die eine Damascene-Struktur mit Luftspalten hat, das die folgenden Schritte umfasst:
- Ablagern einer Opferschicht (PR) und Mustern der Opferschicht, um mindestens ein Muster für einen Damascene-Prozess zu bilden,
- Ablagern einer ersten Barrierenschicht (BL1) auf der gemusterten Opferschicht,
- Ablagern einer Metallschicht (M1), wodurch das Muster gefüllt wird,
- Planarisieren der Metallschicht (M1), wodurch eine Metalllinie gebildet wird,
- Ablagern einer zweiten Barrierenschicht (BL2) auf der planarisierten Metallschicht und der Opferschicht, wodurch die Metalllinien gekapselt werden,
- Planarisieren der zweiten Barrierenschicht (BL2), bis keine Barrierenschicht auf der Oberseite der Opferschicht (PR) vorhanden ist, wodurch die Barrierenschicht oben auf den Metalllinien verbleibt,
- Ablagern einer durchlässigen dielektrischen Schicht (PDL) auf der Opferschicht und auf der Oberseite der planarisierten Metallschicht nach dem Planarisieren der zweiten Barrierenschicht (BL2), und
- Entfernen der gemusterten Opferschicht (PR) durch die durchlässige dielektrische Schicht (PDL), um eine Damascene-Struktur mit Luftspalten (AG) zu bilden, und
**dadurch gekennzeichnet, dass** ein einziger CVD-Reaktor zum Ausführen des Entfernungsschritts durch Erhitzen verwendet wird, um die Opferschicht (PR) zerfallen zu lassen und in einem darauffolgenden Schritt eine dielektrische Schicht abzulagern.

2. Verfahren nach Anspruch 1, wobei die erste und die zweite Barrierenschicht (BL1, BL2) leitfähig sind.

3. Verfahren nach Anspruch 1 oder 2, wobei die Opferschicht (PR) eine Fotoresistschicht oder ein organisches Polymer mit niedriger Masse ist.

4. Verfahren nach einem der Ansprüche 1 bis 3, wobei das Mustern der Opferschicht (PR) angepasst ist, um zusätzliche Muster in der Opferschicht (PR) zu bilden, um Metalldummysstrukturen in dem Luftspalt nach dem Entfernungsschritt bereitzustellen.

## Revendications

1. Procédé de fabrication d'un dispositif semiconducteur ayant une structure damascène avec des entrefers, comprenant les étapes de :
- le dépôt d'une couche jetable (PR) et la structuration de la couche jetable de manière à former au moins un motif pour un processus damascène,
- le dépôt d'une première couche de barrière (BL1) au-dessus de la couche jetable structurée,
- le dépôt d'une couche métallique (M1) en remplissant de ce fait le motif,
- l'aplanissement de ladite couche métallique (M1) en formant de ce fait une ligne métallique,
- le dépôt d'une deuxième couche de barrière (BL2) sur la couche métallique aplanie et la couche jetable en encapsulant de ce fait les lignes métalliques,
- l'aplanissement de ladite deuxième couche de barrière (BL2) jusqu'à ce qu'aucune couche de barrière ne soit présente au-dessus de la couche jetable (PR) et en laissant de ce fait la couche de barrière au-dessus des lignes métalliques,
- le dépôt d'une couche diélectrique perméable (PDL) sur la couche jetable et au-dessus de la couche métallique aplanie après l'aplanissement de ladite deuxième couche de barrière (BL2), et
- l'enlèvement de ladite couche jetable structurée (PR) à travers ladite couche diélectrique perméable (PDL) pour former une structure damascène avec des entrefers (AG) ; et
**caractérisé en ce qu'**un réacteur CVD unique est utilisé pour effectuer l'étape de l'enlèvement par le chauffage afin de décomposer la couche jetable (PR) et pour déposer une couche diélectrique à une étape suivante.

2. Procédé selon la revendication 1, dans lequel lesdites première et deuxième couches de barrière (BL1, BL2) sont conductrices.

3. Procédé selon la revendication 1 ou 2, dans lequel ladite couche jetable (PR) est une couche de photoréserve ou un polymère organique avec une faible masse.

4. Procédé selon l'une quelconque des revendications 1 à 3, dans lequel ladite structuration de ladite couche jetable (PR) est apte à former des motifs supplémentaires dans ladite couche jetable (PR) pour fournir des structures factices métalliques dans l'entrefer après ladite étape de l'enlèvement.
